# EUROPÄISCHE PATENTANMELDUNG

(11) **EP 3 678 167 A1**
(43) Veröffentlichungstag der Anmeldung: **08.07.2020**
(21) Anmeldenummer: 19150486.9
(22) Anmeldetag: 07.01.2019
(51) Int. Cl.: H01L 21/60

(54) **ELEKTRISCHE SCHALTUNG MIT GEFORMTER SCHALTUNGSTRÄGERPLATTE UND AUFGEBRACHTER LEITERBAHN**

(71) Anmelder: Siemens Aktiengesellschaft, 80333 München (DE)
(72) Erfinder: Kiefl, Stefan, 80992 München (DE); Stegmeier, Stefan, 81541 München (DE); Lambrecht, Franziska, 80799 München (DE); Weisbrod, Erik, 80686 München (DE); Lorz, Roland, 91341 Röttenbach (DE); Mauersberger, Markus, 90427 Nürnberg (DE)

(57) **Zusammenfassung**

Die vorliegende Erfindung betrifft eine Schaltungsanordnung (1) erste Bauelemente (3) mit nach oben zeigenden ersten Anschlusskontakten, elektrische Leiterelemente (4), eine um die ersten Bauelemente (3) und die elektrischen Leiterelemente (4) geformte Schaltungsträgerplatte und eine die ersten Anschlusskontakte und/ oder die elektrischen Leiterelemente (4) kontaktierende, aufgebrachter Leiterbahn. Die Erfindung betrifft des Weiteren ein Leistungsmodul (13) und ein Verfahren zur Herstellung einer Schaltungsanordnung (1).

## Beschreibung

### HINTERGRUND DER ERFINDUNG

### Gebiet der Erfindung

Die vorliegende Erfindung betrifft eine Schaltungsanordnung mit ersten Bauelementen mit nach oben zeigenden ersten Anschlusskontakten. Die Erfindung betrifft des Weiteren ein Leistungsmodul mit einer derartigen Schaltungsanordnung sowie ein Verfahren zur Herstellung einer Schaltungsanordnung. Die Erfindung kann insbesondere im Bereich der Leistungselektronik Anwendung finden.

### Beschreibung des Stands der Technik

In Gebieten wie der Mikrosystemtechnik, der Elektronik oder der Leistungselektronik hat die Aufbau- und Verbindungstechnik das Ziel, elektrische Kontakte von passiven Bauelementen (wie z. B. Widerstände), Halbleiterbauelementen (wie z.B. IG-BTs, Dioden, MOSFETs, LEDs, ...) und Substraten (FR4, DCB, ANM, Leadframes, ...) elektrisch miteinander zu verbinden.

Für die unterseitige Verbindung zum Substrat werden hier üblicherweise Verfahren wie das Kleben (Leitkleber), das Löten (Preforms, Lotpasten), das Diffusionslöten oder die Sintertechnologie verwendet. Letztere beide Verfahren haben den entscheidenden Vorteil, dass die entstandene Bauteilverbindung erst bei sehr hohen Temperaturen wieder aufschmilzt.

Für die oberseitigen Kontakte werden üblicherweise Verfahren wie die Wire- oder Bändchen-Bond-Technologie (z.B. aus Au, Al oder Cu) eingesetzt. Diese hat jedoch den entscheidenden Nachteil, dass Druckkräfte vorhanden sind (Gefahr einer Beschädigung des Halbleiterbauelements), im späteren Betrieb lokale Temperaturerhöhungen entstehen (bedingt durch den geringen Querschnitt des Drahtes) und elektrische Störungen entstehen können (elektrische Induktion von parallelen Wire-Bonds).

Alternativ zur herkömmlichen Wire-Bond-Technologie können deshalb planare Aufbau- und Verbindungskonzepte von Vorteil sein (niedrige Induktivität), bei welchen die Leiterbahnen topographisch entlang der Strukturen gelegt werden. Die Realisierung derartiger Leiterbahnen ist jedoch mit sehr hohen Herausforderungen verbunden, da entweder hohe Drücke (Sintern von Leiterbahnen), hohe Prozesskosten (Verwenden von Ag-Sinterpasten) oder ein hoher Komplexitätsgrad (Fototechnologie und Galvanik) vonnöten sind.

Aus der nachveröffentlichen Patentanmeldung DE 10 2017 213 930ist bekannt, dass die Aufbau- und Verbindungstechnologie des Substrats (z.B. Leiterbahnen) und die Anbindung an eine Peripherie (z.B. Lastanschlüsse) gleichzeitig mittels thermischen Sprühens realisiert wird. Hierbei werden Kontakte auf das Substrat gesetzt und oberseitig angesprüht.

Nachteil ist jedoch, dass nicht jede oberseitige Anbindung für eine Kontaktierung geeignet ist, (z.B. bei einer oberseitigen Isolierung eines passiven Bauelements). Des Weiteren müssen durch diesen Ansatz immer Topographien ausgeglichen werden. Ein weiterer Nachteil liegt darin, dass Isolationsstrecken nicht immer eingehalten werden können, da eine Isolation unterhalb des Bauelements schwierig herzustellen ist.

### ZUSAMMENFASSUNG DER ERFINDUNG

Die Aufgabe der Erfindung besteht darin, eine Lösung anzugeben, um aktive und passive Bauelemente, Senseanschlüsse, Lastanschlüsse, etc. in einem Schritt planar anzubinden, ohne die oben beschriebenen Nachteile zu besitzen und insbesondere in der Leistungselektronik zum Einsatz kommen zu können.

Die Erfindung ergibt sich aus den Merkmalen der unabhängigen Ansprüche. Vorteilhafte Weiterbildungen und Ausgestaltungen sind Gegenstand der abhängigen Ansprüche. Weitere Merkmale, Anwendungsmöglichkeiten und Vorteile der Erfindung ergeben sich aus der nachfolgenden Beschreibung.

Erfindungsgemäß wird die Aufgabe gelöst indem durch ein Formverfahren (= Molding Verfahren) eine Leiterplatte um Bauelemente mit nach oben zeigenden elektrischen Kontakten gelegt wird und anschließend auf die nach oben zeigenden Kontakte (d.h. von der Leiterplatte wegzeigend) eine Leiterbahn aufgebracht (z.B. mittels Plasmasprühverfahrens) wird.

Die Erfindung beansprucht eine Schaltungsanordnung. Diese weist erste Bauelemente mit nach oben zeigenden ersten Anschlusskontakten, elektrische Leiterelemente, eine um die ersten Bauelemente und die elektrischen Leiterelemente geformte Schaltungsträgerplatte und eine die ersten Anschlusskontakte und/ oder die elektrischen Leiterelemente kontaktierende, gesprühte Leiterbahn auf.

"Nach oben zeigend" beutet im Zusammenhang mit der Erfindung, dass die Anschlusskontakte oder elektrischen Kontakte zu der Seite zeigen, auf der die Leiterbahn aufgebracht wird, d.h. von der Leiterplatte wegzeigen.

In einer weiteren Ausgestaltung kann die Schaltungsanordnung zusätzlich in der Schaltungsträgerplatte und/oder elektrischen Leiterelementen ausgebildete Kavitäten aufweisen. Die Kavitäten können auch als Mulde oder Loch bezeichnet werden. In den Kavitäten können zweite Bauelemente mit nach oben zeigenden zweiten Anschlusskontakten angeordnet sein. In dieser Ausgestaltung kontaktiert die aufgebrachte Leiterbahn zusätzlich (zu den ersten Anschlusskontakten) die zweiten Anschlusskontakte. Das Aufbringen kann beispielsweise durch Sprühen, insbesondere (z.B. mittels Plasmasprühverfahrens) erfolgen.

Dass die ersten Anschlusskontakte und die zweiten Anschlusskontakte nach oben zeigen, hat den Vorteil, dass diese dadurch frei liegen und nicht vom Material oder Substrat der Schaltungsträgerpatte umgeben sind. So können die ersten Anschlusskontakte und die zweiten Anschlusskontakte durch die aufgebrachte Leiterbahn ein einem einzigen Fertigungsschritt von oben kontaktiert werden. Das Aufbringen kann beispielsweise durch Sprühen, insbesondere (z.B. mittels Plasmasprühverfahrens) erfolgen.

Außerdem können durch das Formen der Schaltungsträgerplatte die Zwischenräume der ersten Bauelemente und/ oder der zweiten Bauelemente und/ oder der elektrischen Leiterelemente mit isolierendem Material gefüllt sein.

Die Kavitäten können dabei in die geformte Schaltungsträgerplatte einerseits additiv (z.B. mittels eines Moldwerkzeuges) oder subtraktiv (z.B. nachträglich mittels Fräsens, Ätzens oder Laserablation) eingebracht werden. Auch in den ersten Bauelementen können Kavitäten additiv (z.B. Prägen vor der Anordnung der zweiten Bauelemente) oder subtraktiv (z.B. nachträglich mittels Fräsens, Ätzens, Laserablation...) vorgesehen werden.

Die zweiten Bauelemente können zum Beispiel in die Kavitäten eingeklebt, eingelötet, gesintert oder mit einem anderen Verfahren eingebracht sein.

In einer weiteren Ausgestaltung sind die ersten Bauelemente und/ oder die zweiten Bauelemente und/ oder die elektrischen Leiterelemente zumindest teilweise bündig mit der Oberfläche der Schaltungsträgerplatte angeordnet.

Dies kann beispielsweise durch die Anpassung der Kavitätentiefe an die Höhe der zweiten Bauelemente erreicht werden. Dies hat den Vorteil, dass die Schaltungsanordnung so zumindest teilweise eine planare Oberfläche aufweist. Eine planare Oberfläche hat wiederum den Vorteil, dass ein einfaches und schnelles Aufbringung einer oberseitigen Aufbau- und Verbindungstechnologie möglich ist.

In einer weiteren Ausgestaltung ist die Schaltungsträgerplatte mittels eines Spritzguss-Verfahrens oder eines Vergießens herstellbar.

In einer weiteren Ausgestaltung ist das Spritzguss-Verfahren Compression Molding, Transfer Molding oder Film Assisted Molding. Es sind jedoch eine Vielzahl weiterer Möglichkeiten, wie zum Beispiel HTCC- & LTCC-Keramiken, Leiterplatten oder DBCs realisierbar.

Zur Durchführung des Molding-Prozesses oder Molding-Verfahrens können die ersten Bauteile zum Beispiel vorab auf eine Tragfläche z.B. eine Klebefolie aufgebracht werden. Alternativ ist z.B. eine Ätzung einer metallischen Folie mit nachfolgender Bauteilbestückung möglich. Anschließend folgt der Molding-Prozess. Hierbei wird die geformte Schaltungsträgerplatte aus einem Moldmaterial (auch als Substrat bezeichenbar) geformt bzw. spritzgegossen.

In einer weiteren Ausgestaltung ist zwischen der aufgebrachten (insbesondere gesprühten) Leiterbahn und der Schaltungsträgerplatte und/ oder den ersten Bauelementen und/ oder den zweiten Bauelementen zumindest teilweise eine Isolationsschicht aufgebracht.

Die Isolation kann mit allen heute in der Literatur bekannten Verfahren aufgebracht sein (gesprüht, gedruckt, dispensed, gerakelt, laminiert...) und aus allen bekannten isolierenden Stoffklassen (Polymere, Hochtemperaturpolymere, Siloxane, Keramiken...) gebildet sein. Die Isolation hat den Vorteil, dass sie bei späteren Prozessschritten einen Hitzeschutz für das Substratpolymer bietet.

In einer weiteren Ausgestaltung ist die aufgebrachte (insbesondere gesprühte) Leiterbahn als eine strukturierte Metallisierung aufgebracht.

Das aufgebrachte Material für die Leiterbahnen bzw. zur Anbindung der ersten Bauelemente und zweiten Bauelemente besteht vorzugsweise aus einem elektrisch leitfähigen Material, wie z.B. Metalle, Halbleiter, Metall-Keramikverbindungen oder einem Material, welches durch einen nachfolgenden Behandlungsschritt (Temperatur, UV-Licht, ...) elektrisch leitfähig wird. Vorzugsweise werden Cu, Ag, Au, Al, Ni, Sn oder Legierungen daraus verwendet.

In einer weiteren Ausgestaltung ist die strukturierte Metallisierung mittels thermischen Sprühens aufgebracht. Dadurch hat die gesprühte Leiterbahn den Vorteil, dass die elektrische Kontaktierung in einem einzigen Herstellschritt vorgenommen wird.

Das thermische Sprühverfahren ist hierbei als übergeordneter Begriff anzusehen. Unterverfahren sind hierbei z.B. Zerstäuben aus einer Schmelze (Schmelzbadspritzen), elektrische Lichtbogen- oder Gasentladung (z.B. Lichtbogenspritzen oder Plasmaspritzen), Gasexpansion ohne Verbrennung (z.B. Kaltgasspritzen), Verbrennung (z.B. Drahtflammspritzen, Pulverflammspritzen, Hochgeschwindigkeitsflammspritzen, Detonationspritzen) oder gebündelter energetischer Strahl (z.B. Laserspritzen) .
Alle Verfahren haben den Vorteil, dass eine mechanische Verklammerung bzw. eine metallurgische Verbindung erreicht und gleichzeitig eine elektrische Verbindung geschaffen wird.

Neben dem thermischen Sprühverfahren sind auch weitere Metallisierungsarten für die obere Aufbau- und Verbindungstechnologie denkbar, wie z.B. Chemical Vapor Deposition (CVD), Physical Vapor Deposition (PVD), Schmelztauchen, Aerosol Deposition Methode (ADM), Drucken von Metallpastensysteme (z.B. Siebdruck, Schablonendruck, Inkjetdruck, Jetting-Druck), Laserbeschichtung/ Laserauftragsschweißen oder Galvanik (stromunterstützt, außenstromfrei).

In einer weiteren Ausgestaltung sind die ersten Bauelemente und die zweiten Bauelemente passive elektrische Bauteile und/ oder aktive elektrische Bauteile. Die passiven Bauelemente können z.B. Widerstände, NTC-Widerstände, Kondensatoren oder Halbleiterchips sein.

In einer weiteren Ausgestaltung sind die elektrischen Leiterelemente aus Kupfer, Aluminium, Molybdän oder anderen Metallen gebildet. Dies hat die Vorteile einer hohen Stromtragfähigkeit und sehr guten Eigenschaften bzgl. der Wärmespreizung.

Die Erfindung beansprucht außerdem ein Leistungsmodul mit einer erfindungsgemäßen Schaltungsanordnung.

In einer weiteren Ausgestaltung weist das Leistungsmodul eine Schaltungsanordnung mit einem Einzelschalter oder/ und einer Halbbrücke auf.

Die Erfindung beansprucht auch ein Verfahren zur Herstellung einer erfindungsgemäßen Schaltungsanordnung. Das Verfahren beinhaltet ein Formen der Schaltungsträgerplatte um die ersten Bauelemente und die elektrischen Leiterelemente, wobei die ersten Anschlusskontakte frei liegen und ein Aufbringen, insbesondere ein Aufsprühen einer Leiterbahn, die die ersten Anschlusskontakte und/ oder die elektrischen Leiterelemente kontaktiert.

Die Erfindung beansprucht außerdem ein Verfahren zur Herstellung einer weiteren Ausgestaltung einer erfindungsgemäßen Schaltungsanordnung. Das Verfahren beinhaltet ein Formen der Schaltungsträgerplatte um die ersten Bauelemente und elektrische Leiterelemente, wobei die ersten Anschlusskontakte frei liegen, ein Erstellen von den Kavitäten in der Schaltungsträgerplatte und/oder den elektrischen Leiterelementen, ein Anordnen der zweiten Bauelemente in den Kavitäten, wobei die zweiten Anschlusskontakte nach oben zeigen und ein Aufbringen, insbesondere ein Aufsprühen einer Leiterbahn, die die ersten Anschlusskontakte und/ oder die elektrischen Leiterelemente und/ oder die zweiten Anschlusskontakte kontaktiert.

### KURZE BESCHREIBUNG DER ZEICHNUNGEN

Die Besonderheiten und Vorteile der Erfindung werden aus den nachfolgenden Erläuterungen mehrerer Ausführungsbeispiele anhand von schematischen Zeichnungen ersichtlich.

Es zeigen
- Fig. 1: eine Schaltungsanordnung mit ersten Elementen,
- Fig. 2: eine Schaltungsanordnung mit ersten und zweiten Elementen,
- Fig. 3: eine Schaltungsanordnung und
- Fig. 4: ein Blockschaltbild eines Leistungsmoduls.

### DETAILLIERTE BESCHREIBUNG DER ERFINDUNG

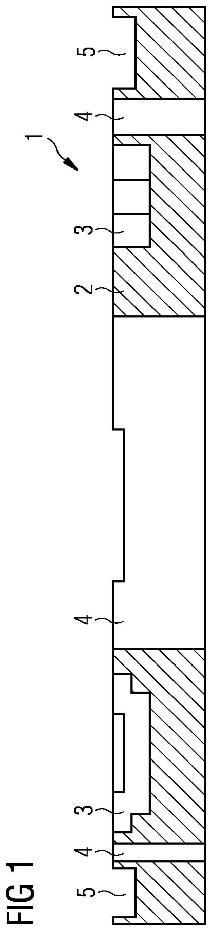

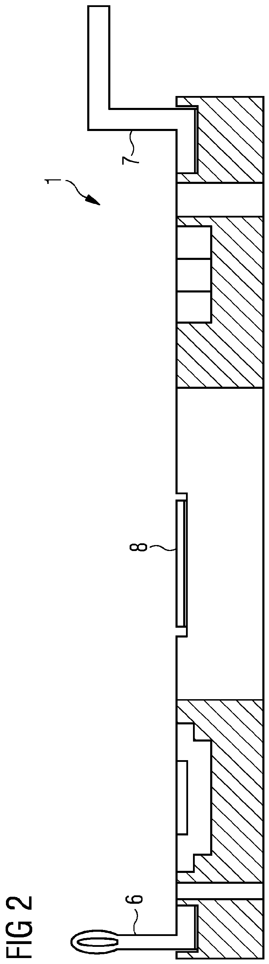

Fig. 1 zeigt eine schematische Schnittansicht einer Schaltungsträgerplatte 1 mit ersten Bauelementen 3 und elektrischen Leiterelementen 4, welche von einem Mold-Material 2 umgeben sind. Dies kann zum Beispiel durch einen Molding-Prozess realisiert werden. Die ersten Bauelemente können zum Beispiel Kondensatoren oder Widerstände sein. Die elektrischen Leiterelemente 4 können zum Beispiel aus Kupfer sein. Die elektrischen Leiterelemente 4 und das Mold-Material 2 können Kavitäten aufweisen. Kavitäten können auch als Mulde oder Loch bezeichnet werden. Die Kavitäten können wie in Fig. 2 gezeigt zur Aufnahme zweiter Bauelemente verwendet werden.

Das Mold-Material ist bevorzugt ein Kunststoff, beispielsweise Polypropylen oder mit Keramikpartikeln versetztes Epoxid.

Fig. 2 zeigt zusätzlich zu den auch in Fig. 1 dargestellten Elementen eine Schaltungsanordnung mit einem Sense-Anschluss 6 (z.B. Pressfit), einem Last-Anschluss 7 und einem Halbleiterbauelement 8 (z.B. Diode, IGBT, MOSFET) als Beispiele für zweite Bauelemente.

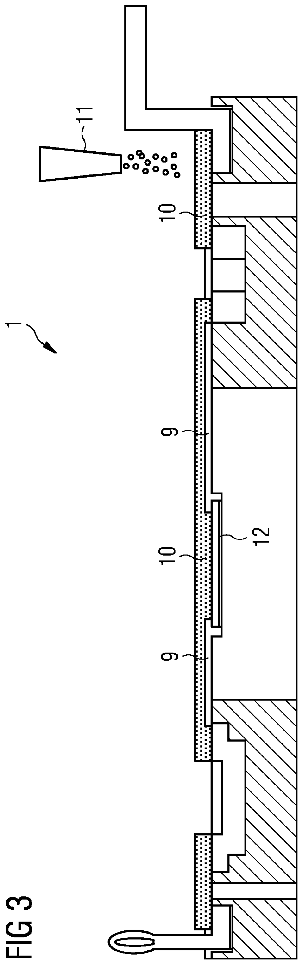

Fig. 3 zeigt zusätzlich zu den auch in Fig. 1 und Fig. 2 dargestellten Elementen eine Schaltungsanordnung mit einem Isolationsmaterial 9 und einer durch eine Sprühdüse 11 aufgebrachte Metallisierung 10. Das Isolationsmaterial 9 kann zum Beispiel mittels Druckprozess aufgebracht sein. Die Metallisierung 10 kann zum Beispiel mittels thermischen Sprühens aufgebracht sein.

Zwischen dem elektrischen Leiterelement 4 und dem Halbleiterbauelement 8 sitzt eine elektrische Verbindung 12. Diese ermöglicht eine darunterliegende und darüberliegende elektrische Verbindung. Dies ist für spezielle Schaltungen von Vorteil, z.B. sind Halbbrücken so einfach und robust realisierbar. Zusätzlich führt das elektrische Leiterelement 4 Hitze des Halbleiterbauelements 8 zum Beispiel an einen darunterliegend angeordneten nicht dargestellten Kühler ab.

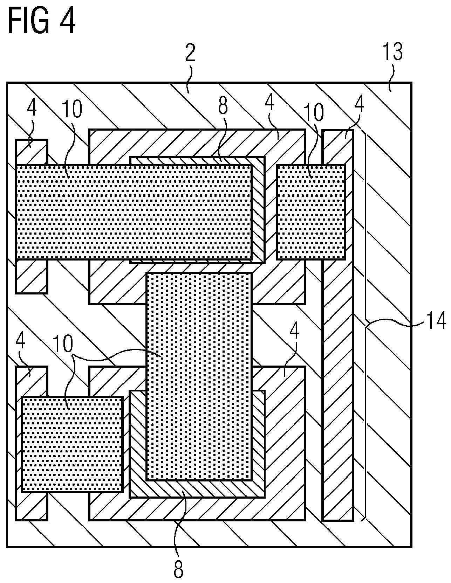

Fig. 4 zeigt ein Blockschaltbild eines Leistungsmoduls 13 mit einer Halbbrücke 14 als Beispiel einer Schaltungsanordnung 1. Die Halbbrücke weist Halbleiter 8, eine Metallisierung 10, elektrische Leiterelemente 4 und Mold-Material 2 auf.

Obwohl die Erfindung im Detail durch die Ausführungsbeispiele näher illustriert und beschrieben wurde, ist die Erfindung durch die offenbarten Beispiele nicht eingeschränkt und andere Variationen können vom Fachmann daraus abgeleitet werden, ohne den Schutzumfang der Erfindung zu verlassen.

## Patentansprüche

1. Schaltungsanordnung (1),
**gekennzeichnet durch:**
- erste Bauelemente (3) mit nach oben zeigenden ersten Anschlusskontakten,
- elektrische Leiterelemente (4),
- eine um die ersten Bauelemente (3) und die elektrischen Leiterelemente (4) geformte Schaltungsträgerplatte und
- eine die ersten Anschlusskontakte und/ oder die elektrischen Leiterelemente (4) kontaktierende, aufgebrachte Leiterbahn.

2. Schaltungsanordnung (1) nach Anspruch 1,
**gekennzeichnet durch:**
- in der Schaltungsträgerplatte und/oder in den elektrischen Leiterelementen (4) ausgebildete Kavitäten und
- in den Kavitäten angeordnete zweite Bauelemente mit nach oben zeigenden zweiten Anschlusskontakten,
- wobei die aufgebrachte Leiterbahn zusätzlich die zweiten Anschlusskontakte kontaktiert.

3. Schaltungsanordnung (1) nach einem der vorhergehenden Ansprüche, **dadurch gekennzeichnet,**
**dass** die ersten Bauelemente (3) und/ oder die zweiten Bauelemente zumindest teilweise bündig mit der Oberfläche der Schaltungsträgerplatte angeordnet sind.

4. Schaltungsanordnung (1) nach einem der vorhergehenden Ansprüche, **dadurch gekennzeichnet,**
**dass** die Schaltungsträgerplatte mittels eines Spritzguss-Verfahrens oder eines Vergießens herstellbar ist.

5. Schaltungsanordnung (1) nach Anspruch 4, **dadurch gekennzeichnet,**
**dass** das Spritzguss-Verfahren Compression Molding oder Transfer Molding oder Film Assisted Molding ist.

6. Schaltungsanordnung (1) nach einem der vorhergehenden Ansprüche,
**wobei** zwischen der aufgebrachten Leiterbahn und der Schaltungsträgerplatte und/ oder den ersten Bauelementen (3) und/ oder den zweiten Bauelementen zumindest teilweise eine Isolationsschicht aufgebracht ist.

7. Schaltungsanordnung (1) nach einem der vorhergehenden Ansprüche,
**wobei** die aufgebrachte Leiterbahn als eine strukturierte Metallisierung (10) aufgebracht ist.

8. Schaltungsanordnung (1) nach Anspruch 7,
**wobei** die strukturierte Metallisierung (10) mittels thermischen Sprühens aufgebracht ist.

9. Schaltungsanordnung (1) nach einem der vorhergehenden Ansprüche, **dadurch gekennzeichnet,**
**dass** die ersten Bauelemente (3) und die zweiten Bauelemente passive elektrische Bauteile und/ oder aktive elektrische Bauteile sind.

10. Schaltungsanordnung (1) nach einem der vorhergehenden Ansprüche, **dadurch gekennzeichnet,**
**dass** die elektrischen Leiterelemente (4) aus Kupfer, Aluminium, Molybdän oder anderen Metallen gebildet sind.

11. Leistungsmodul (13) mit einer Schaltungsanordnung (1) nach einem der vorherigen Ansprüche.

12. Leistungsmodul (13) nach Anspruch 11 wobei die Schaltungsanordnung (1) einen Einzelschalter oder/ und eine Halbbrücke (14) aufweist.

13. Verfahren zur Herstellung einer Schaltungsanordnung (1) nach Anspruch 1, aufweisend die folgenden Schritte:
- ein Formen der Schaltungsträgerplatte um die ersten Bauelemente (3) und die elektrischen Leiterelemente (4), wobei die ersten Anschlusskontakte frei liegen und
- ein Aufbringen einer Leiterbahn, die die ersten Anschlusskontakte und/ oder die elektrischen Leiterelemente (4) kontaktiert.

14. Verfahren zur Herstellung einer Schaltungsanordnung (1) nach Anspruch 2, aufweisend die folgenden Schritte:
- ein Formen der Schaltungsträgerplatte um die ersten Bauelemente (3) und elektrische Leiterelemente (4), wobei die ersten Anschlusskontakte frei liegen,
- ein Erstellen von den Kavitäten in der Schaltungsträgerplatte und/oder den elektrischen Leiterelementen (4),
- ein Anordnen der zweiten Bauelemente in den Kavitäten, wobei die zweiten Anschlusskontakte nach oben zeigen und
- ein Aufbringen einer Leiterbahn, die die ersten Anschlusskontakte und/ oder die elektrischen Leiterelemente (4) und/ oder die zweiten Anschlusskontakte kontaktiert.
